# EUROPÄISCHE PATENTANMELDUNG

(11) **EP 1 736 841 A1**
(43) Veröffentlichungstag der Anmeldung: **27.12.2006**
(21) Anmeldenummer: 06114516.5
(22) Anmeldetag: 24.05.2006
(51) Int. Cl.: G05B 19/4062

(54) **Verfahren zur automatisierten Prüfung eines Stellers**

(30) Priorität: 22.06.2005 DE 102005028810
(71) Anmelder: ROBERT BOSCH GMBH, 70442 Stuttgart (DE)
(72) Erfinder: Dingler, Thomas, 70435, Stuttgart (DE); Ott, Michael, 69151, Neckargemuend (DE); Sepe, Nello, 72669, Unterensingen (DE)

(57) **Zusammenfassung**

Bei einem Verfahren zur Prüfung eines Stellers (1) mit mindestens einem Eingang (2), der mit einer Eingangsgröße (E) beaufschlagt werden kann und mindestens einem Ausgang (3) an dem eine Ausgangsgröße (A) anliegen kann wird eine automatisierte Prüfung ermöglicht, indem die Eingangsgröße (E) verändert wird und der Steller (1) als fehlerhaft eingestuft wird wenn sich die Ausgangsgröße (A) bei Übergang von einem ersten Wert der Eingangsgröße (Pos (n)) auf einen zweiten Wert der Eingangsgröße (Pos(n+1)) um einen Wert kleiner als ein Mindestwert (x) ändert.

## Beschreibung

### Stand der Technik

Die vorliegende Erfindung betrifft ein Verfahren sowie eine Vorrichtung zur Prüfung eines Stellers mit mindestens einem Eingang und mindestens einem Ausgang.

Bei der Prüfung eines Stellers, beispielsweise eines elektrischen oder hydraulischen Stellers, auf dessen Kennlinie Ausgang zu Eingang wird der Steller an seinem Eingang mit einem elektrischen, hydraulischen, pneumatischen oder dergleichen Signal beaufschlagt und es wird an dessen Ausgang das Ausgangssignal z.B. mittels eines Weg-, Kraft-, Spannungs-, Stromsensors oder dergleichen bestimmt. Dann wird eine Kennlinie aufgestellt zwischen der Eingangsgröße und der mittels des Sensors gemessenen Ausgangsgröße. Problematisch bei einem Steller sind so genannte "hängende Bereiche", in denen eine Änderung des Eingangssignals keine oder nur eine geringfügige Änderung des Ausgangssignals bewirken. Derzeit erfolgt eine Überprüfung eines Stellers hauptsächlich optisch manuell, in dem eine graphisch aufgetragene Kennlinie z.B. mit einer Hüllkurve oder einer Vorgabekennlinie verglichen wird. Zusätzlich oder alternativ können zur Plausibilität einzelne Prüfpunkte, sprich Eingabewerte für den Steller, mit den zugehörigen Sensorwerten verglichen werden. Problematisch an der Vorgehensweise, insbesondere der manuellen Beurteilung der Stellerkennlinie, ist, dass keine genauen Bewertungskriterien vorgebbar sind, beispielsweise bleibt es dem mit der Prüfung beauftragten Mitarbeiter überlassen, ob die Abweichung von einer Sollkurve tolerierbar ist oder ob diese bereits zu groß ist.

Aus der DE10354656 ist beispielsweise ein Verfahren zum Überwachen eines Einspritzsystems einer Brennkraftmaschine bekannt, wobei das Einspritzsystem einen Kraftstoffspeicher und eine gesteuerte Zumesseinheit zum Steuern der Kraftstoff-Fördermenge in den Kraftstoffspeicher aufweist. Verfahren dieser Art werten ein Signal, welches den zeitlichen Verlauf des Druckes in dem Kraftstoffspeicher repräsentiert, im Hinblick auf einen möglichen Defekt einer Komponente des Einspritzsystems aus. Um gezielt auf einen Defekt der Zumesseinheit schließen zu können, wird dort vorgeschlagen, die Zumesseinheit während der Auswertung des den Druck im Kraftstoffspeichers repräsentierenden Signals zunehmend weiter zu schließen oder zu öffnen.

### Probleme des Standes der Technik

Derzeit bekannte Verfahren zur Prüfung eines Stellers bedürfen manueller Kontrollschritte und sind deshalb nicht oder nur unter großem Aufwand automatisierbar. Aufgabe der vorliegenden Erfindung ist es daher, ein Verfahren sowie eine Vorrichtung anzugeben, die eine automatisierte Prüfung und Auswertung ohne Eingriff von Prüfpersonal ermöglichen.

### Vorteile der Erfindung

Dieses Problem wird gelöst durch ein Verfahren zur Prüfung eines Stellers mit mindestens einem Eingang, der mit einer Eingangsgröße beaufschlagt werden kann und mindestens einem Ausgang, an dem eine Ausgangsgröße anliegen kann, wobei die Eingangsgröße verändert wird und der Steller als fehlerhaft eingestuft wird, wenn sich die Ausgangsgröße bei Übergang von einem ersten Wert der Eingangsgröße auf einen zweiten Wert der Eingangsgröße um einen Wert kleiner als ein Mindestwert ändert.

Die Eingangsgröße kann beispielsweise ein elektrisches, hydraulisches oder pneumatisches Signal oder dergleichen sein, ebenso kann die Ausgangsgröße ein elektrisches, pneumatisches, hydraulisches oder mechanisches Signal (Wert) sein. Der Steller kann beispielsweise ein elektromechanischer Aktor, ein elektrohydraulischer Aktor, ein Ventil oder dergleichen sein. Das erfindungsgemäße Verfahren bietet den Vorteil, dass dieses automatisiert durchgeführt werden kann. Des weiteren kann die Prüfung über den gesamten Arbeitsbereich, mithin den gesamten Stellbereich des Stellers, erfolgen. Die Prüfung ergibt eine eindeutige Aussage bezüglich fehlerfreier bzw. des aufgetretenen Fehlers, dieser kann sogar einem Stellbereich zugeordnet werden, und muss nicht aufgrund eines Vergleichs mit Vergleichsmessungen bestimmt werden. Die Grenzwerte für die Prüfung können relativ eng gewählt werden, da immer nur die Veränderung von einem zum nächsten Wert geprüft wird und kein absoluter Wert gemessen werden muss. Die Prüfung kann erfolgen, indem die Eingangsgröße schrittweise verändert wird.

In einer Weiterbildung des Verfahrens kann zusätzlich zu dem Wert der Änderung der Ausgangsgröße der absolute Wert der Ausgangsgröße bei dem ersten und/oder zweiten Wert der Eingangsgröße mit einem Sollwert verglichen werden. Zusätzlich zur Veränderung des Ausgangswertes wird damit auch der absolute Wert bewertet und geht in die Funktionsprüfung ein.

Die Ausgangsgröße kann in einer Weiterbildung mit einer Verzögerungszeit gegenüber der Veränderung der Eingangsgröße gemessen werden. Dies ist insbesondere sinnvoll, wenn der Steller selbst als Regelstrecke eine längere Zeit zum Erreichen eines Sollwertes am Ausgang benötigt, beispielsweise durch eine Verzögerung (Totzeit), starke Dämpfung, Einschwingungsvorgänge oder dergleichen.

Vorzugsweise wird die Ausgangsgröße mittels eines Sensors, der ein die Ausgangsgröße repräsentierendes Sensorsignal generiert, gemessen. Der Sensor setzt die Ausgangsgröße, die z.B. mechanisch, thermisch, elektrisch oder dergleichen sein kann, in ein elektrisches Signal, das automatisiert weiterverarbeitet werden kann, um. Der Sensor kann Teil einer Messvorrichtung sein, kann aber auch in dem Steller z.B. als Teil einer internen Regelung integriert sein. Dabei kann das Sensorsignal ein analoges oder digitales elektrisches Signal sein.

Das Sensorsignal kann in einer Weiterbildung als Mittelwert mehrerer Abtastungen gemessen werden. Dadurch können Mess- und Stellungenauigkeiten kompensiert werden. Der Mindestwert kann abhängig vom Wert der Eingangsgröße sein, um z.B. nichtlineare Verstärkungen zu berücksichtigen.

Das Eingangs genannte Problem wird auch gelöst durch eine Vorrichtung zur Prüfung eines Stellers mit mindestens einem Eingang, der mit einer Eingangsgröße beaufschlagt werden kann und mindestens einem Ausgang, an dem eine Ausgangsgröße anliegen kann, wobei die Eingangsgröße veränderbar ist und der Steller als fehlerhaft eingestuft werden kann, wenn sich die Ausgangsgröße bei Übergang von einem ersten Wert der Eingangsgröße auf einen zweiten Wert der Eingangsgröße um einen Wert kleiner als ein Mindestwert ändert.

Das Verfahren läuft somit vorzugsweise unter Nutzung der erfindungsgemäßen Vorrichtung wie folgt ab: Zunächst wird der Steller auf einen Startpunkt gefahren. Über den Sensor wird das daraus resultierende Signal sodann erfasst. Nach einer eventuellen Verzögerungszeit wird das Signal abgespeichert, wobei eventuell auch ein Mittelwert über mehrere Abtastungen gespeichert werden kann. Sodann wird die Position des Stellers verändert, wobei hier vorzugsweise eine relativ kleine Änderung erfolgt. Über den Sensor wird nach einer eventuell erneuten Verzögerungszeit das nächste Signal erfasst, wobei auch hier ein Mittelwert über mehrere Abtastungen erfolgen kann. Das nun gemessene neue Signal muss um einen Wert X, der gegebenenfalls abhängig von der Stellerposition sein kann, größer oder kleiner (abhängig von der Wirkungsweise und einer positiven bzw. negativen Kennlinie des Stellers) sein als das alte Signal, ansonsten wird ein Fehler erkannt.

Beim nächsten Schritt wird wieder die Position des Stellers verändert, wobei auch dies vorzugsweise in einem kleinen Schritt erfolgt. Über den Sensor wird nach einer eventuellen erneuten Verzögerungszeit das nächste Signal erfasst, wobei auch hier wiederum eventuell ein Mittelwert über mehrere Abtastungen erfolgen kann. Auch nun muss das neue Signal um den Faktor bzw. Wert X größer oder kleiner sein als das vorherige Signal, ansonsten wird ein Fehler erkannt. Das Verfahren wird also schleifenartig durchlaufen, wobei im vorhergehenden Absatz zwei dieser Schleifen erläutert wurden.

### Zeichnungen

Nachfolgend wird ein Ausführungsbeispiel der vorliegenden Erfindung anhand der beiliegenden Zeichnung näher erläutert. Dabei zeigen:
- Fig. 1: eine Skizze einer Stellerkennlinie;
- Fig. 2: eine Skizze einer hängenden Stellerkennlinie;
- Fig. 3: ein Ablaufdiagramm des erfindungsgemäßen Verfahrens;
- Fig. 4: eine Skizze einer erfindungsgemäßen Vorrichtung.

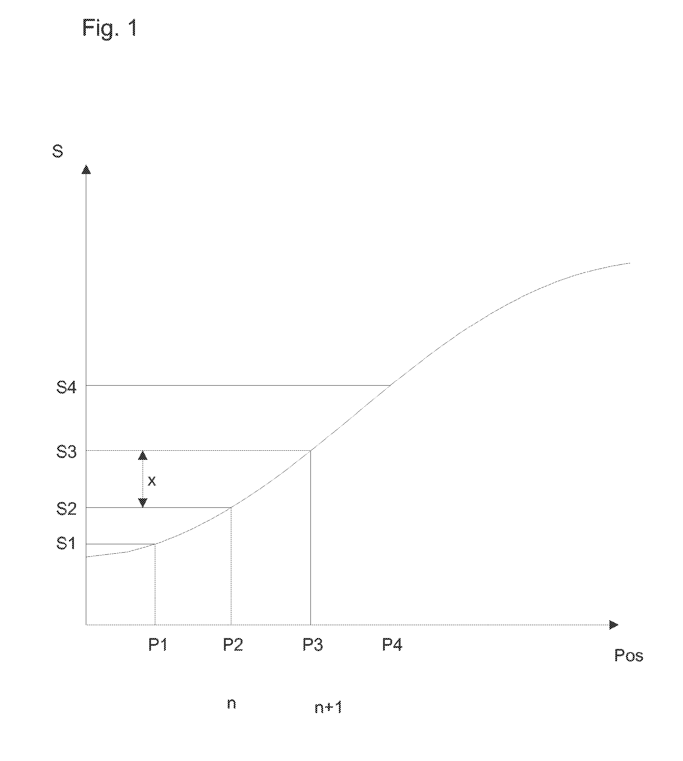

Fig. 1 zeigt ein Sensorsignal S aufgetragen über eine Stellerposition POS. Die Stellerposition POS ist das Eingangssignal eines beliebigen Stellers, beispielsweise eine elektrische Spannung, ein elektrischer Strom, ein Hydraulik- oder Pneumatikdruck, eine Kraft, ein Weg oder dergleichen. Das Sensorsignal S repräsentiert die Ausgangsgröße des Stellers, der Sensor liefert z.B. ein elektrisches Signal, das eine physikalische Ausgangsgröße des Stellers, beispielsweise eine elektrische Spannung, ein elektrischer Strom, ein Hydraulik- oder Pneumatikdruck, eine Kraft, ein Weg oder dergleichen repräsentiert. Das Sensorsignal S über der Stellerposition POS ergibt eine Kennlinie K, deren Graph hier willkürlich zu Darstellungszwecken gewählt ist. Im Idealfall ergibt sich ein z.B. linearer oder ein nichtlinearer Zusammenhang S=F(POS) zwischen Sensorsignal und Stellerposition POS und damit zwischen der Eingangs- und Ausgangsgröße des Stellers. In dem in der Praxis benutzten Bereich eines Stellers weist dieser eine positive oder negative Steigung des Graphen des Sensorsignals S über der Stellerposition POS auf, wie dies mit einer positiven Steigung in Fig. 1 dargestellt ist. Betrachtet man mehrere Stellerpositionen, z.B. wie in Fig. 1 dargestellt P1, P2, P3, P4, so sind diesen jeweils Sensorsignale S1, S2, S3, S4 zugeordnet. Unterschiedlichen Stellerpositionen POS sind unterschiedliche Sensorsignale S zugeordnet. Beim Übergang von einem ersten Wert einer Stellerposition N auf einen zweiten Wert der Stellerposition N+1, hier beispielsweise anhand der Position P2 und P3 dargestellt, wird sich also das Sensorsignal S um einen Wert X=S(N+1)-S(N) verändern. Für eine vorgegebene Stellerkennlinie kann ein Mindestwert X angegeben werden, für die in Fig. 1 dargestellten Bereiche wäre dies X=S2-S1, der als Mindestwert einer Veränderung beim Übergang von einer Stellerposition N auf eine Stellerposition N+1 auftreten muss.

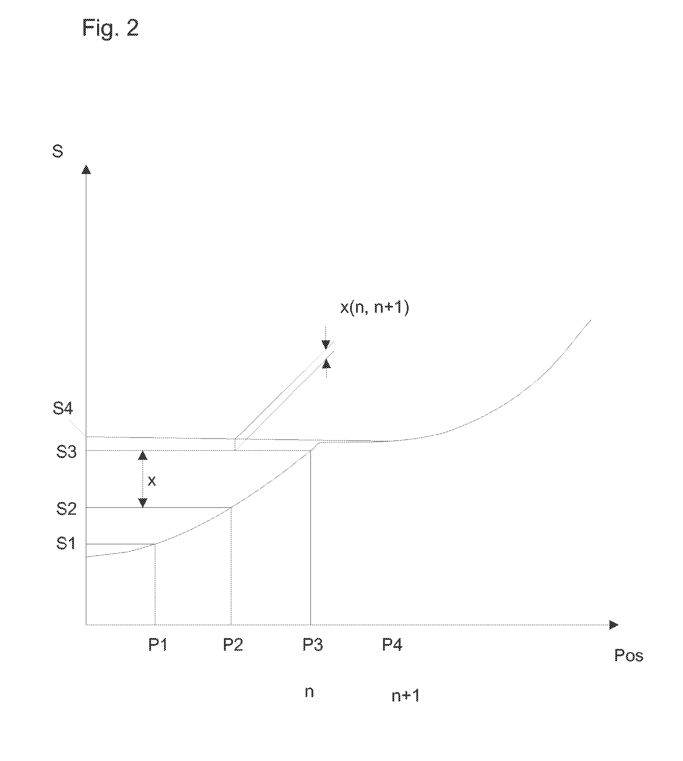

Fig. 2 zeigt eine Darstellung ähnlich der Fig. 1, bei der zwischen den Stellerpositionen P3 und P4 ein so genannter hängender Bereich vorkommt, in dem also das Sensorsignal sich nicht oder, wie in Fig. 2 dargestellt, nur unerheblich ändert. Eine Veränderung des Eingangssignals hat also keine entsprechende Änderung des Ausgangssignals zur Folge. Beim Übergang der Stellerposition P3 auf P4 ändert sich das Sensorsignal S3 um den Wert X(N, N+1)in das Sensorsignal S4. Der Wert X(N, N+1)=S4-S3 ist wesentlich kleiner als der Wert X, der die Mindestdifferenz zweier aufeinander folgender Sensorsignale beim Übergang der Stellerposition von N auf N+1 markiert.

Es wird also beim Übergang einer Stellerposition N auf eine Stellerposition N+1 gemessen, ob der Gradient ΔS=S(N+1)-S(N) einen Mindestwert erreicht. Ist dies nicht der Fall, so hängt der Steller (oder der Sensor zur Ermittlung der Stellerposition). Zusätzlich kann geprüft werden, ob der Istwert jeweils einen Sollwert erreicht.

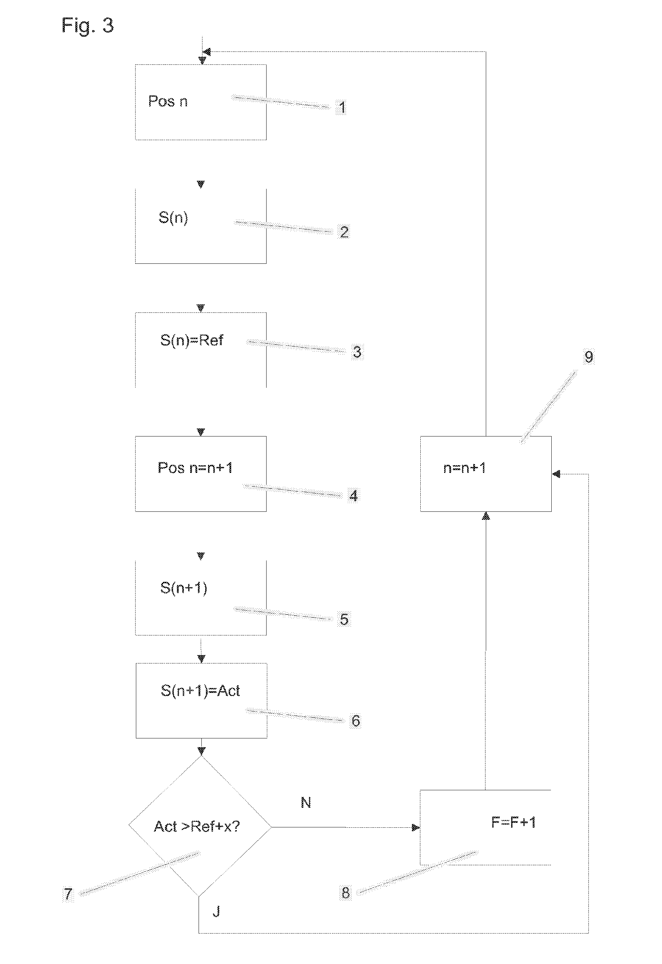

In Fig. 3 ist das erfindungsgemäße Verfahren in einem Ablaufdiagramm dargestellt. Beginnend mit einer Stellerposition N im Schritt 1 wird im Schritt 2 das Sensorsignal S(N), das der Stellerposition N zugeordnet ist, gelesen. In Schritt 3 wird das Sensorsignal S(N) aus Schritt 2 als Referenzwert Ref abgespeichert. Im darauf folgenden Schritt 4 wird der Steller in eine weitere Position N+1 gefahren. In Schritt 5 wird das Sensorsignal, das zur Stellerposition N+1 gehört, als S(N+1) ausgelesen. In Schritt 6 wird das Sensorsignal S(N+1) als aktuelles Sensorsignal Act abgespeichert. In Schritt 7 folgt ein Vergleich, ob das aktuelle Sensorsignal Act größer ist als das Referenzsignal Ref zuzüglich eines positiven oder negativen Wertes X. Der Wert X entspricht (wie zuvor erläutert) einem Mindestwert, um den sich das Sensorsignal beim Übergang von einem Stellerwert N auf einen Stellerwert N+1 ändern muss. Je nach positiver oder negativer mithin steigender oder fallender Kennlinie des Stellers ist der Wert X positiv oder negativ. Wird die Frage in Schritt 7 mit 'Nein' (N) beantwortet, ist also der aktuelle Wert des Sensorsignales Act nicht größer als der Referenzwert Ref zuzüglich der Mindestveränderung X, so wird zunächst ein Fehlerzähler um 1 erhöht, F=F+1 (Schritt 8), danach wird in Schritt 9 ein Zähler N für die Stellerposition um 1 erhöht, N=N+1. Wurde die Frage in Schritt 7 mit 'Ja' (gekennzeichnet durch den Buchstaben J) beantwortet, so wird der Fehlerspeicher F nicht verändert und direkt in einem Schritt 9 der Zähler N für die Stellerposition um 1 erhöht, N=N+1.

In den Schritten 3 und 5 des Verfahrens, wenn also die Sensorsignale S(N) bzw. S(N+1) gemessen werden, kann es notwendig sein, zunächst einen stationären Wert des Stellers, wenn dieser also die angestrebte Position erreicht hat, abzuwarten und den Messwert erst nach einer Verzögerungszeit ΔT zu ermitteln. Des weiteren kann es, je nach Art des Stellers, notwendig sein, mehrere Messzyklen hintereinander zu reihen, den Wert des Stellers also über mehrere Messungen bei ein und der selben Position des Stellers zu mitteln.

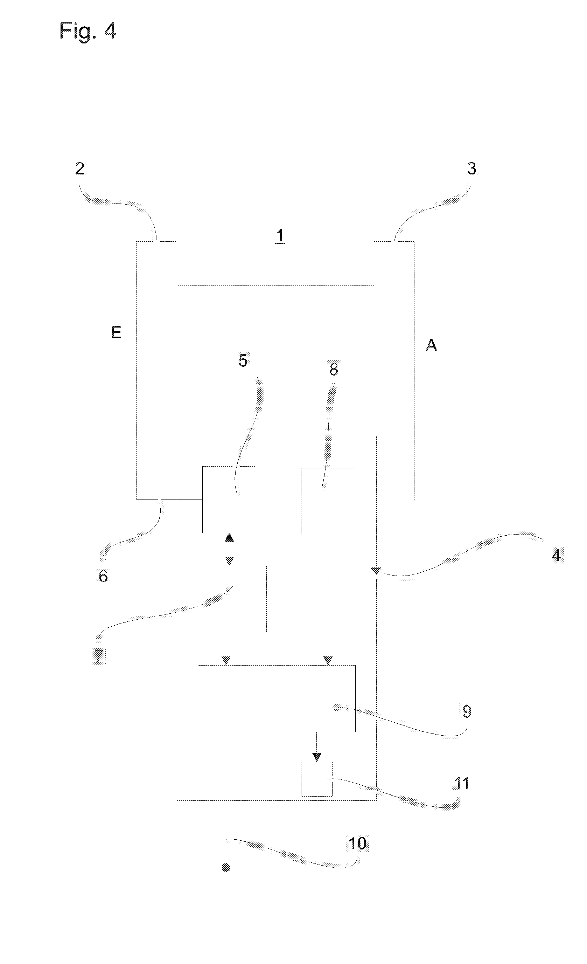

Fig. 4 zeigt eine Anordnung zur Durchführung des erfindungsgemäßen Verfahrens. Ein Steller 1 mit einem Eingang 2 und einem Ausgang 3 wird durch eine Prüfvorrichtung 4 eingangsseitig mit einer Eingangsgröße E beaufschlagt. Dazu umfasst die Prüfvorrichtung 4 eine Ausgangsstufe 5, die an einem Ausgang 6 die Eingangsgröße E für den Steller 1 bereitstellt. Die Eingangsgröße E kann eine elektrische, hydraulische, pneumatische, mechanische, optische usw., mithin beliebige physikalische Größe sein. Die Ausgangsstufe 5 ist elektrisch verbunden mit einer Regelstufe 7, die als Treiber das Ausgangssignal, das gleich dem Eingangssignal E des Stellers 1 ist, der Ausgangsstufe 5 steuert. Die Regelstufe 7 wird mit einer analogen oder digitalen elektrischen Größe E_E beaufschlagt, welche die physikalische Größe E am Eingang 2 des Stellers 1 repräsentiert. Der Doppelpfeil zwischen Regelstufe 7 und Ausgangsstufe 5 soll verdeutlichen, dass hier eine Rückmeldung der Ausgangsstufe 5 über die tatsächlich beaufschlagte physikalische Größe am Eingang 2 des Stellers erfolgen kann.

Der Ausgang 3 des Stellers 1 liefert wiederum eine physikalische Größe, die jedoch eine andre Größe als die des Eingangs 2 sein kann. Beispielsweise kann ein elektromechanischer Aktor eingangsseitig mit einer elektrischen Größe (Spannung) beaufschlagt sein, ausgangsseitig eine mechanische Größe liefern wie Kraft und Weg. Ein hydraulischer Steller z.B. kann mit einer hydraulischen Größe beaufschlagt sein und eine mechanische Größe liefern, ein elektrischer Verstärker kann Ein- und Ausgangsseitig elektrische Größen haben. Diese physikalische Größe A wird von einem Sensor 8 der Prüfvorrichtung 4 in ein elektrisches Sensorsignal S umgewandelt. Das Sensorsignal S repräsentiert die physikalische Größe A am Ausgang 3 des Stellers.

Ein Auswerteglied 9 beaufschlagt zum Einen die Regelstufe 7 mit einem Sollsignal E_S und wertet zum Anderen die die physikalische Größe A repräsentierende elektrische Messgröße des Sensorsignals S aus. Dabei erfolgt ein Vergleich des Istwertes der physikalische Größe A mit dem Sollwert E_S gemäß dem zuvor beschriebenen Verfahren. Das Auswerteglied 9 enthält dazu die zuvor in dem Verfahren genannten Zähler und dergleichen z.B. in Form eines Computerprogramms einer speicherprogrammierbaren Steuerung. Des Weiteren kann ein Interface 10 zum Datentransfer sowie eine Anzeigeeinheit 11 z.B. für Bedienpersonal zur Weitergabe bzw. Weiterverarbeitung der Mess- und/oder Prüfergebnisse vorgesehen sein.

## Patentansprüche

1. Verfahren zur Prüfung eines Stellers (1) mit mindestens einem Eingang (2), der mit einer Eingangsgröße (E) beaufschlagt werden kann und mindestens einem Ausgang (3) an dem eine Ausgangsgröße (A) anliegen kann, **dadurch gekennzeichnet, dass** die Eingangsgröße (E) verändert wird und der Steller (1) als fehlerhaft eingestuft wird, wenn sich die Ausgangsgröße (A) bei Übergang von einem ersten Wert der Eingangsgröße (Pos (n)) auf einen zweiten Wert der Eingangsgröße (Pos(n+1)) um einen Wert kleiner als ein Mindestwert (x) ändert.

2. Verfahren nach Anspruch 1, **dadurch gekennzeichnet, dass** zusätzlich zu dem Wert der Änderung der Ausgangsgröße (A) der absolute Wert der Ausgangsgröße (E) bei dem ersten und/oder zweiten Wert der Eingangsgröße (Pos (n), Pos(n+1)) mit einem Sollwert (E_S) verglichen wird.

3. Verfahren nach einem der vorhergehenden Ansprüche, **dadurch gekennzeichnet, dass** die Ausgangsgröße (A) mit einer Verzögerungszeit (tVz) gegenüber der Veränderung der Eingangsgröße (E) gemessen wird.

4. Verfahren nach einem der vorhergehenden Ansprüche, **dadurch gekennzeichnet, dass** die Ausgangsgröße (A) mittels eines Sensors (8), der ein die Ausgangsgröße (A) repräsentierendes Sensorsignal (S) generiert, gemessen wird.

5. Verfahren nach Anspruch 1, **dadurch gekennzeichnet, dass** das Sensorsignal (S) ein analoges oder digitales elektrisches Signal ist.

6. Verfahren nach einem der vorhergehenden Ansprüche, **dadurch gekennzeichnet, dass** das Sensorsignal (S) als Mittelwert mehrerer Abtastungen gemessen wird.

7. Verfahren nach einem der vorhergehenden Ansprüche, **dadurch gekennzeichnet, dass** der Mindestwert (x) abhängig vom Wert der Eingangsgröße (E) ist.

8. Vorrichtung (4) zur Prüfung eines Stellers (1) mit mindestens einem Eingang (2), der mit einer Eingangsgröße (E) beaufschlagt werden kann und mindestens einem Ausgang (3), an dem eine Ausgangsgröße (A) anliegen kann, **dadurch gekennzeichnet, dass** die Eingangsgröße (E) veränderbar ist und der Steller (1) als fehlerhaft eingestuft werden kann, wenn sich die Ausgangsgröße (A) bei Übergang von einem ersten Wert der Eingangsgröße (Pos (n)) auf einen zweiten Wert der Eingangsgröße (Pos(n+1)) um einen Wert kleiner als ein Mindestwert (x) ändert.
